# EUROPÄISCHE PATENTANMELDUNG

(11) **EP 1 326 275 A2**
(43) Veröffentlichungstag der Anmeldung: **09.07.2003**
(21) Anmeldenummer: 02028592.0
(22) Anmeldetag: 20.12.2002
(51) Int. Cl.: H01L 23/36, H01L 23/14

(54) **Leistungselektronikeinheit**

(30) Priorität: 03.01.2002 DE 10200066
(71) Anmelder: SIEMENS AKTIENGESELLSCHAFT, 80333 München (DE)
(72) Erfinder: Thyzel, Bernd, 61479 Schlossborn (DE)

(57) **Zusammenfassung**

Die Erfindung bezieht sich auf eine Leistungselektronikeinheit mit einem flächigen Trägerelement, auf dem Leiterbahnen 4 zur elektrischen Verbindung von ebenfalls auf dem Trägerelement befindlichen elektrischen Leistungsbauelementen 6 und Steuerbauelementen 7 einer Schaltung angeordnet sind. Das Trägerelement ist ein Kühlkörper 1, auf dem die Leiterbahnen 4 mittels eines Wärmeleitklebers 3 aufgebracht sind und durch Abstandshalter 4 im Wärmeleitkleber 3 eine solche Mindestdikke des Wärmeleitklebers 3 sichergestellt ist, dass der Wärmeleitkleber 3 eine elektrische Isolationsschicht ist.

## Beschreibung

Die Erfindung bezieht sich auf eine Leistungselektronikein heit sowie auf ein Verfahren zur Herstellung einer Leistungselektronikeinheit, insbesondere für ein Gerät in einem Kraftfahrzeug, mit einem flächigen Trägerelement , auf dem Leiterbahnen zur elektrischen Verbindung von ebenfalls auf dem Trägerelement befindlichen elektrischen Leistungsbauelementen und Steuerbauelementen einer Schaltung angeordnet sind.

Bei derartigen Leistungselektronikeinheiten ist es bekannt, die Leiterbahnen sowie die Leistungsbauelemente und Steuerbauelemente auf einem isolierenden Trägerelement anzuordnen, das ein Keramiksubstrat, eine Leiterplatte oder ein DCB-Substrat sein kann. Zur Abfuhr der durch die Leistungselektronik erzeugten Wärme müssen dann gesonderte Mittel angewandt werden.

Diese Leistungselektronikeinheiten sind bauteil- und bauraumaufwendig und benötigen einen großen Herstellungsaufwand.

Aufgabe der Erfindung ist es daher eine Leistungselektronikeinheit und ein Verfahren zur Herstellung einer Leistungselektronikeinheit zu schaffen, die einfach und mit wenigen Bauteilen aufgebaut ist, einen geringen Bauraum erfordert, in einfacher Weise eine Ableitung der von den Leistungsbauelementen erzeugten Wärme ermöglicht und mit wenigen, einfachen Schritten herstellbar ist.

Diese Aufgabe wird erfindungsgemäß dadurch gelöst, dass das Trägerelement ein Kühlkörper ist, auf dem die Leiterbahnen mittels eines Wärmeleitklebers aufgebracht sind und durch Abstandshalter im Wärmeleitkleber eine solche Mindestdicke des Wärmeleitklebers sicher gestellt ist, dass der Wärmeleitkleber eine elektrische Isolationsschicht ist. Dabei erfüllt das Trägerelement die Doppelfunktion des Substrats und des Kühlkörpers, wobei jegliches kostengünstiges geeignetes, auch elektrisch leitendes Material für das Trägerelement benutzt werden kann, da der Wärmeleitkleber ebenfalls in Doppelfunktion neben der Wärmeübertragung auch zur elektrischen Isolation dient. Zur Sicherstellung der Funktion der elektrischen Isolation muss der Wärmeleitkleber eine Mindestdicke besitzen. Diese wird auf einfach herstellbare Weise durch die Abstandshalter sichergestellt. Die Anordnung der Wärme produzierenden Leistungsbauelemente sehr nahe dem Kühlkörper sowie die minimierte Isolatorschichtdicke führt zu einer guten thermischen Kopplung der Leistungsbauelemente an dem Kühlkörper und somit zu einer guten und weitgehend direkten Wärmeabfuhr.
Eine besonders gute Wärmeabfuhr wird erreicht, wenn der Kühlkörper aus einem wärmeleitenden Metall besteht, wozu Aluminium oder eine Aluminiumlegierung wegen seiner zusätzlich leichten Verarbeitbarkeit besonders geeignet ist.

Weiterhin führt es zu einer Doppelfunktion eines Bauteils und damit zur Einsparung von Bauraum und Herstellungsaufwand, wenn der Kühlkörper ein Gehäusebauteil eines die Leistungselektronik aufnehmenden Gehäuses ist.

Sind die Leiterbahnen durch Ausstanzen oder Ausätzen aus einer Kupferfolie erzeugt, so benötigt dies nur wenig Herstellungsaufwand.

Um sicher ein Aufeinanderliegen von Abstandshaltern bei der Herstellung der Leistungselektronik zu vermeiden, können die Abstandshalter kugelförmig sein.

Vorzugsweise bestehen dabei die Abstandshalter aus einem elektrisch und wärmeisolierenden Werkstoff wie insbesondere Glas.

Die gestellt Aufgabe wird weiterhin durch ein Verfahren zur Herstellung einer Leistungselektronikeinheit gelöst, bei dem aus einer Kupferfolie mittels Stanzen oder Ätzen ein Muster an Leiterbahnen erzeugt und mittels eines Wärmeleitklebers auf einen flächigen Kühlkörper aufgebracht wird, in welchem Abstandhalter eingemischt sind, dass anschließend unter Andruck des Musters von Leiterbahnen an den Kühlkörper der Warmeleitkleber ausgehärtet wird und dass danach das Muster an Leiterbahnen mit den Leistungsbauelementen und den Steuerbauelementen bestückt und verlötet wird.

Zu diesem Verfahren sind nur wenige und einfache Herstellungsschritte nötig, so dass die Leistungselektronikeinheit kostengünstig herstellbar ist. Um das Muster an Leiterbahnen einfach auf den Kühlkörper aufbringen zu können, ohne dass es dabei zu einer Veränderung der räumlichen Zuordnung der Leiterbahnen zueinander und möglicherweise auch zu einem Kurzschluss zwischen den Leiterbahnen kommen kann, kann die Kupferfolie vor dem Stanzen oder Ätzen von einem Klebeband bedeckt sein, das nach dem Aufbringen des Musters an Leiterbahnen auf den Kühlkörper entfernt wird.

Dabei kann das Klebeband vor oder auch nach dem Aushärten des Wärmeleitklebers entfernt werden.

Bei Verwendung entsprechender Materialien für das Klebeband kann die Entfernung des Klebebands auch durch Vergasung während des Aushärtprozesses erfolgen.
Zu einem einfachen Arbeitsgang führt es, wenn der Wärmeleitkleber auf den Kühlkörper aufgedruckt und anschließend das ausgestanzte oder ausgeätzte Muster an Leiterbahnen auf den aufgedruckten Wärmeleitkleber aufgebracht wird.

Eine weitere Möglichkeit zur Lösung der Aufgabe besteht darin, dass bei einem Verfahren zur Herstellung einer Leistungselektronikeinheit eine Kupferfolie mittels eines Wärmeleitklebers, in den Abstandshalter eingemischt sind, auf einen Kühlkörper aufgebracht wird, danach unter Andruck der Kupferfolie an den Kühlkörper der Wärmeleitkleber ausgehärtet wird, anschließend durch Ätzen ein Muster an Leiterbahnen aus der Kupferfolie erzeugt wird und dass anschließend das Muster an Leiterbahnen mit den Leistungsbauelementen und den Steuerbauelementen bestückt und verlötet wird. Dadurch kann auch die Handhabung eines instabilen Musters an Leiterbahnen erleichtert werden.

Zur Aushärtung des Wärmeleitklebers bei den o.g. Verfahren kann zusätzlich eine Wärmebeaufschlagung des Wärmeleitklebers erfolgen.

In einfach handhabbarer Weise kann der Wärmeleitkleber auf den Kühlkörper aufgedruckt und anschließend die Kupferfolie auf den aufgedruckten Wärmeleitkleber aufgebracht werden. Zum Ätzen der Kupferfolie wird diese mit einem Fotolack beschichtet, unter vorheriger Auflage einer Maske mit negativ ausgespartem Muster an Leiterbahnen belichtet und anschließend einem Ätzvorgang unterzogen.

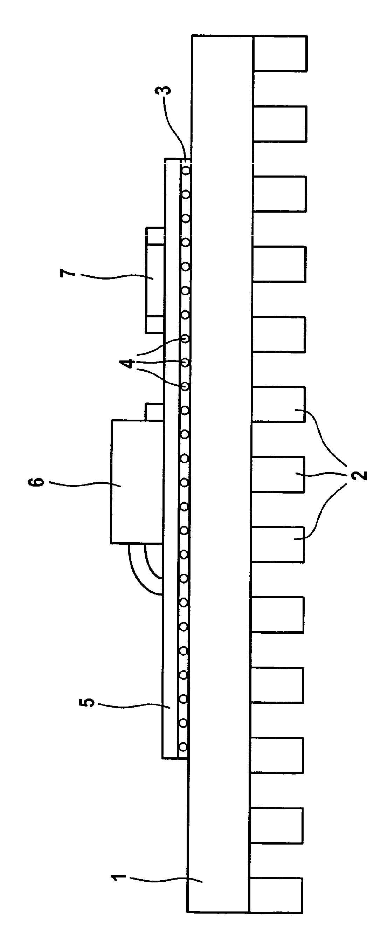

Ein Ausführungsbeispiel der Erfindung ist in der Zeichnung dargestellt und wird im folgenden näher beschrieben. Die einzige Figur der Zeichnung zeigt eine Leistungselektronikeinheit in der Seitenansicht.

Die dargestellte Leistungselektronikeinheit besitzt einen flächigen Kühlkörper 1 aus Aluminium, dessen obere Seite eben und dessen untere Seite mit Kühlrippen 2 versehen ist. Durch einen Druckvorgang ist auf die obere ebene Seite des Kühlkörpers 1 eine Schicht eines Wärmeleitklebers 3 aufgebracht, in den kugelförmige Abstandshalter 4 aus Glas eingemischt sind. Auf diese Schicht des Wärmeleitklebers 3 ist ein Muster von aus einer Kupferfolie ausgeätzten Leiterbahnen 5 aufgebracht, die bei der Herstellung auf die Schicht des Wärmeleitklebers 3 aufgelegt und dann auf den Wärmeleitkleber 3 bis zur Anlage an den Abstandshaltern 4 aufgedrückt wurden. Dabei ergab sich eine durch den Wärmeleitkleber 3 gebildete elektrische Isolationsschicht, deren Dicke durch den Durchmesser der Abstandhalter 4 bestimmt wird. Diese Abstandshalter 4 wurden mit einem Durchmesser gewählt, der eine elektrische Isolierung der Leiterbahnen 5 zum Kühlkörper 1 sicherstellt.

Zur einfachen Handhabung des ausgeätzten Musters an Leiterbahnen 5 war dieses Muster vollständig von einem Klebeband bedeckt, durch das dieses Muster stabilisiert war. Während des Andrückens der Leiterbahnen 5 wurde die gesamte Einheit gleichzeitig wärmebeaufschlagt, wodurch der Wärmeleitkleber 3 ausgehärtet wurde. Anschließend wurde das Klebeband von den Leiterbahnen 5 abgezogen und Leistungsbauelemente 6 und Steuerbauelemente 7 aufgebracht und mit den Leiterbahnen 4 verlötet.

Eine solche Leistungselektronikeinheit kann z.B. vorteilhaft bei Stelleinrichtungen im Kraftfahrzeug angewandt werden, wie sie z.B. zur Drosselklappenverstellung in Drosselklappenstutzen benötigt werden. Aber auch im Kleinleistungsbereich wie bei Sensoren und elektrischen Steckverbindern ist eine Anwendung vorteilhaft möglich.

## Patentansprüche

1. Leistungselektronikeinheit, insbesondere für ein Gerät in einem Kraftfahrzeug, mit einem flächigen Trägerelement , auf dem Leiterbahnen zur elektrischen Verbindung von ebenfalls auf dem Trägerelement befindlichen elektrischen Leistungsbauelementen und Steuerbauelementen einer Schaltung angeordnet sind, **dadurch gekennzeichnet, dass** das Trägerelement ein Kühlkörper (1) ist, auf dem die Leiterbahnen (5) mittels eines Wärmeleitklebers (3) aufgebracht sind und durch Abstandshalter (4) im Wärmeleitkleber (3) eine solche Mindestdicke(3) eine elektrische Isolationsschicht ist.

2. Leistungselektronikeinheit nach Anspruch 1, **dadurch gekennzeichnet, dass** der Kühlkörper (1) aus einem wärmeleitenden Metall besteht.

3. Leistungselektronikeinheit nach Anspruch 2, **dadurch gekennzeichnet, dass** der Kühlkörper (1) aus Aluminium oder einer Aluminiumlegierung besteht.

4. Leistungselektronikeinheit nach einem der vorhergehenden Ansprüche, **dadurch gekennzeichnet, dass** der Kühlkörper ein Gehäusebauteil eines die Leistungselektronik aufnehmenden Gehäuses ist.

5. Leistungselektronikeinheit nach einem der vorhergehenden Ansprüche, **dadurch gekennzeichnet, dass** die Leiterbahnen (5) durch Ausstanzen oder Ausätzen aus einer Kupferfolie erzeugt sind.

6. Leistungselektronikeinheit nach einem der vorhergehenden Ansprüche, **dadurch gekennzeichnet, dass** die Abstandshalter (4) kugelförmig sind.

7. Leistungselektronikeinheit nach einem der vorhergehenden Ansprüche, **dadurch gekennzeichnet, dass** die Abstandshalter (4) aus einem elektrisch und wärmeisolierenden Werkstoff bestehen.

8. Leistungselektronikeinheit nach Anspruch 7, **dadurch gekennzeichnet, dass** die Abstandshalter (4) aus Glas bestehen.

9. Verfahren zur Herstellung einer Leistungselektronikeinheit nach einem der vorhergehenden Ansprüche, **dadurch gekennzeichnet, dass** aus einer Kupferfolie mittels Stanzen oder Ätzen ein Muster an Leiterbahnen (5) erzeugt und mittels eines Wärmeleitklebers (3) auf einen flächigen Kühlkörper (1) aufgebracht wird, in welchem Abstandshalter (4) eingemischt sind, dass anschließend unter Andruck des Musters von Leiterbahnen (5) an den Kühlkörper (1) der Wärmeleitkleber (3) ausgehärtet wird und dass danach das Muster an Leiterbahnen (5) mit den Leistungsbauelementen (6) und den Steuerbauelementen (7) bestückt und verlötet wird.

10. Verfahren nach Anspruch 9, **dadurch gekennzeichnet, dass** die Kupferfolie vor dem Stanzen oder Ätzen von einem Klebeband bedeckt ist, das nach dem Aufbringen des Musters an Leiterbahnen (5) auf den Kühlkörper (1) entfernt wird.

11. Verfahren nach Anspruch 10, **dadurch gekennzeichnet , dass** das Klebeband vor oder nach dem Aushärten des Wärmeleitklebers (3) entfernt wird.

12. Verfahren nach einem der Ansprüche 9 bis 11, **dadurch gekennzeichnet, dass** der Wärmeleitkleber (3) auf den Kühlkörper (1) aufgedruckt und anschließend das ausgestanzte oder ausgeätzte Muster an Leiterbahnen (5) auf den aufgedruckten Wärmeleitkleber (3) aufgebracht wird.

13. Verfahren zur Herstellung einer Leistungselektronikeinheit nach einem der Ansprüche 1 bis 8, **dadurch gekennzeichnet, dass** eine Kupferfolie mittels eines Wärmeleitklebers, in den Abstandshalter eingemischt sind, auf einen Kühlkörper aufgebracht wird, danach unter Andruck der Kupferfolie an den Kühlkörper der Wärmeleitkleber ausgehärtet wird, anschließend durch Ätzen ein Muster an Leiterbahnen aus der Kupferfolie erzeugt wird und dass anschließend das Muster an Leiterbahnen mit den Leistungsbauelementen und den Steuerbauelementen bestückt und verlötet wird.

14. Verfahren nach einem der Ansprüche 9 bis 11 und 13, **dadurch gekennzeichnet, dass** der Wärmeleitkleber (3) unter zusätzlicher Wärmebeaufschlagung ausgehärtet wird.

15. Verfahren nach Anspruch 13, **dadurch gekennzeichnet, dass** der Wärmeleitkleber auf den Kühlkörper aufgedruckt und anschließend die Kupferfolie auf den aufgedruckten Wärmeleitkleber aufgebracht wird.

16. Verfahren nach einem der Ansprüche 9 bis15, **dadurch gekennzeichnet, dass** zum Ätzen die Kupferfolie mit einem Fotolack beschichtet, unter vorheriger Auflage einer Maske mit negativ ausgespartem Muster an Leiterbahnen (5) belichtet und anschließend einem Ätzvorgang unterzogen wird.
